Europäisches Patentamt

European Patent Office

Office européen des brevets

(11) Veröffentlichungsnummer: **0 510 221 A1**

## (12) EUROPÄISCHE PATENTANMELDUNG

(21) Anmeldenummer: **91106527.4**

(22) Anmeldetag: **23.04.91**

(51) Int. Cl.5: **H03K 19/003**, H03K 17/14, H03K 3/01

(43) Veröffentlichungstag der Anmeldung:
**28.10.92 Patentblatt 92/44**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Koelz, Johann, Dipl.-Ing.**
**Hilblestrasse 30**
**W-8000 München 19(DE)**

(54) **Anordnung zur Optimierung des Betriebsverhaltens von MOS-Treiberstufen in taktgesteuerten digitalen Schaltungen.**

(57) Die erfindungsgemäße Anordnung besitzt einen Steuer- oder Regelkreis, der es ermöglicht, die Ausgangsstufen in digitalen MOS-Schaltungen mit einem optimalen Betriebsverhalten zu betreiben. Dazu werden die Schaltzeiten der Ausgangsstufen gesteuert. Hierzu wird das Verhältnis von Betriebsfrequenz und einer Referenzfrequenz gebildet und daraus ein Steuersignal für die Ausgangsstufen gebildet.

FIG 1

EP 0 510 221 A1

Rank Xerox (UK) Business Services

Die Erfindung betrifft eine Anordnung zur Optimierung des Betriebsverhaltens von MOS-Treiberstufen in taktgesteuerten digitalen Schaltungen. Derartige MOS-Treiberstufen sind komplementär aufgebaut und z. B. aus Tietze/Schenk Halbleiterschaltungstechnik, 8. Auflage 1986, S. 211 ff. bekannt. Auf Seite 212 Abb. 9.36 ist hier ein CMOS-Inverter dargestellt, welcher aus zwei komplementären Transistoren T1, T2 besteht. Das Eingangssignal wird den beiden Gateanschlüssen der beiden Transistoren zugeführt. Die Laststrecken der beiden Transistoren sind in Reihe geschaltet und mit dem Bezugspotential $V_{DD}$ sowie Masse verbunden. Am Knotenpunkt der Reihenschaltung kann das Ausgangssignal abgegriffen werden.

Ausgangstreiber in MOS- und CMOS-Schaltungen zeigen in ihrem Betriebsverhalten große Schwankungen in Abhängigkeit von Versorgungsspannung, Temperatur, Fertigungstoleranzen und auch Belastung. Die EMV-Abstrahlung eines Bausteins ist sehr stark mit der Treiberfähigkeit derartiger Ausgangstreiber korreliert. Da die Verarbeitungsgeschwindigkeit von Mikroprozessoren, welche derartige Treiber enthalten, immer höher wird, stellt die EMV-Abstrahlung derartiger Bausteine in zunehmendem Maße ein Problem für den Anwender dar.

Aufgabe der Erfindung ist daher eine Anordnung zur Optimierung des Betriebsverhaltens von MOS-Treiberstufen in taktgesteuerten digitalen Schaltungsanordnungen mit möglichst geringer EMV-Abstrahlung anzugeben.

Diese Aufgabe wird durch den kennzeichnenden Teil des Anspruchs 1 gelöst. Weiterbildungen sind Kennzeichen der Unteransprüche. Vorteil der Erfindung ist es, daß die erfindungsgemäße Anordnung sich an die jeweiligen Betriebszustände anpaßt. Änderungen der Versorgungsspannung, der Temperatur sowie Fertigungstoleranzen können so auf einfache Weise ausgeglichen werden.

Die Erfindung wird nachfolgend anhand von vier Figuren näher erläutert. Es zeigen

FIG 1 ein Prinzipschaltbild der erfindungsgemäßen Anordnung,

FIG 2 ein Prinzipschaltbild einer weiteren erfindungsgemäßen Ausführungsform,

FIG 3 eine erste regelbare Treiberstufe in MOS-Technik und

FIG 4 eine zweite Treiberstufe in MOS-Technik.

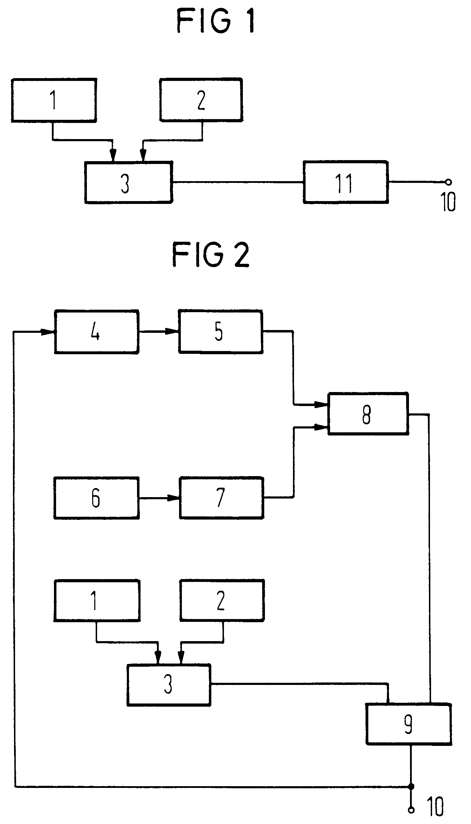

Grundprinzip der Erfindung ist daß Mittel vorgesehen sind, die die tatsächliche Betriebsfrequenz ins Verhältnis zu einer Referenzfrequenz setzen und dementsprechend ein Signal erzeugen, welches als Steuergröße für eine steuerbare Treiberstufe verwendet wird. FIG 1 zeigt hierzu den prinzipiellen Aufbau. Mit 1 ist z. B. der extern zugeführte Systemtakt dargestellt. 2 stellt eine Einheit dar, die innerhalb des integrierten Schaltkreises einen Referenzwert erzeugt. Dies kann z. B. ein Referenzoszillator sein. Die Ausgangssignale der beiden Einheiten 1, 2 werden nun einer verhältnisbildenden Einheit 3 zugeführt. Das Ausgangssignal der verhältnisbildenden Einheit wird dann weiter einer Einheit 11 zugeführt. Diese Einheit 11 bildet nun die Stellgröße für einen steuerbaren Treiber, welche an der Ausgangsklemme 10 abgegriffen werden kann.

FIG 2 stellt eine erweiterte Anordnung zur Regelung des Betriebsverhaltens einer Treiberstufe dar. Gegenüber der in FIG 1 gezeigten Anordnung enthält die in FIG 2 dargestellte Anordnung zusätzlich eine steuerbare Treiberstufe 4. Weiterhin ist eine nichtsteuerbare Referenztreiberstufe 6 dargestellt. Die beiden Treiberstufen 4, 6 sind jeweils Einheiten 5, 7 nachgeschaltet, welche zur Schaltzeitprüfung dienen. Diese Einheiten ermitteln die Schaltzeit der jeweiligen Treiberstufen. Die Ausgangssignale der beiden Einheiten 5, 7 werden einer Einheit 8 zur Verhältnisbildung zugeführt. Ein Komparator 9 ist vorgesehen, dem die Ausgangssignale der beiden Einheiten zur Verhältnisprüfung 3, 8 zugeführt werden. Das Ausgangssignal der Komparatoreinheit 9 dient als Stellgröße für den regelbaren Treiber 4. Außerdem wird es einem Ausgang 10 zugeführt an dem die Stellgröße für die einzelnen im Schaltkreis befindlichen Treiberstufen abgegriffen werden kann.

Mit dem auf dem integrierten Schaltkreis befindlichen Referenz-Oszillator 2, dessen Schwingfrequenz von der Versorgungsspannung, der Bausteintemperatur und den Fertigungstoleranzen gleichermaßen wie das aktuelle Betriebsverhalten der Treiberstufen abhängt, wird eine Referenzgröße erzeugt. In der Einheit 3 wird nun das arithmetische Verhältnis zwischen dieser Referenzfrequenz und der tatsächlichen Betriebsfrequenz 1 welche von außen zugeführt wird, gebildet. Das so erzeugte Ausgangssignal dient als Stellglied für den Regelkreis. In der erweiterten Anordnung gemäß FIG 2 kann nun zusätzlich die Schaltzeit eines geregelten ReferenzTreibers 4 und die eines ungeregelten Referenztreibers 6 verglichen werden. Ist das Verhältnis der beiden Schaltzeiten gleich dem Verhältnis der beiden Taktfrequenzen, so ist das optimale Betriebsverhalten der gesamten Anordnung gewährleistet. Die Ausgangssignale der beiden verhältnisbildenden Einheiten werden zu diesem Zweck von einem Komparator verglichen. Das Ausgangssignal des Komparators dient wiederum als Stellgröße für den Regelkreis.

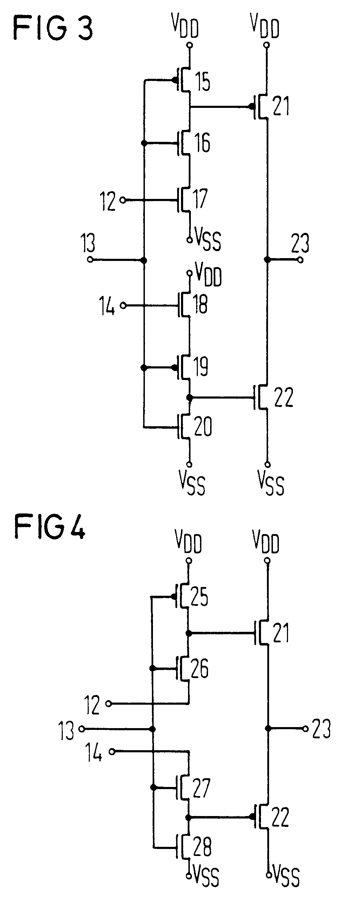

Ein wie oben beschriebener regelbarer Ausgangstreiber ist in FIG 3 dargestellt. Dieser besteht z. B. aus drei komplementär aufgebauten Stufen. Diese Stufen sind entsprechend dem zuvor genannten Stand der Technik aufgebaut und mit den Betriebsspannungsanschlüssen $V_{DD}$ und $V_{SS}$ verbunden. So enthält jede Stufe zwei komplementäre MOS-Transistoren 15, 16; 19, 20; 21, 22. Die beiden ersten Stufen 15, 16 sowie 19, 20, welche zueinander komplementär aufgebaut sind und vom gleichen Eingangssignal angesteuert werden, sind nun in ihrer Schaltzeit steuerbar. Dies wird dadurch bewerkstelligt, daß den Reihenschaltungen der Laststrecken der beiden komplementären Transistoren 15, 16; 19, 20 jeweils eine Laststrecke eines zusätzlichen Transistors 17; 18 in Reihe geschaltet ist. Der erste Transistor 17 ist dabei in Reihe gegen $V_{SS}$ geschaltet, wo hingegen der zweite Transistor 18 in Reihe gegen die Betriebsspannung $V_{DD}$ geschaltet ist. Die Gateanschlüsse der zusätzlichen Transistoren 17, 18 sind jeweils mit Eingängen 12, 14 verbunden. An diesen Eingängen 12, 14 ist nun ein Signal zuführbar, welches von dem Steuersignal von den in den Figuren 1 und 2 dargestellten Ausgangsanschluß 10 ableitbar ist. Die dritte Stufe bestehend aus den Transistoren 21 und 22 ist in normaler Weise aufgebaut, die Eingänge der beiden Transistoren sind jeweils mit den Ausgängen der ersten und der zweiten Treiberstufe verbunden. Das Ausgangssignal der gesamten Anordnung kann an einer Ausgangsklemme 23 abgegriffen werden, welche mit dem Knotenpunkt der Reihenschaltung der Laststrecken der Transistoren 21 und 22 verbunden ist.

In Abhängigkeit von dem benötigten Betriebsverhalten der integrierten Schaltungen wird an der Anschlußklemme 12 eine Spannung mit dem Wert: $V_{SS} + U_{TN} < U_{12} < V_{DD}$ angelegt. $U_{TN}$ stellt dabei die Einsatzspannung des Transistors 17 dar, welcher vom n-Kanal Typ ist. Eine höhere Spannung wird an den Anschluß 12 dann angelegt, wenn die Betriebsspannung im unteren Spezifikationsbereich liegt und/oder die Betriebstemperatur im oberen Spezifikationsbereich liegt und/oder die Technologie Bausteine mit niedriger Stromergiebigkeit der Transistoren geliefert hat und der Systemtakt maximal ist. In Analogie dazu wird in Abhängigkeit von dem benötigten Betriebsverhalten der integrierten Schaltung an der Anschlußklemme 14 eine Spannung mit dem Wert $V_{DD} - U_{TP} > U_{14} > U_{SS}$ angelegt. $U_{TP}$ stellt hier die Einsatzspannung des Transistors 18 dar, welcher vom p-Kanal Typ ist. Die beiden Spannungen $U_{12}$ und $U_{14}$ sind die Steuerspannungen, welche an den Anschlüssen 12 und 14 anliegen und welche direkt aus dem am Anschluß 10 anliegenden Steuersignal ableitbar sind. Auf diese Weise wird durch die zusätzlichen Transistoren 17, 18 eine Verzögerung der Ansteuerung der Ausgangstreiber erreicht. Dadurch erreicht man eine flachere Ansteuerflanke mit einem Spannungshub, der der Betriebsspannung entspricht und somit strombegrenzend für die Ausgangstransistoren 21 und 22 wirkt.

FIG 4 zeigt eine weitere Ausführungsform eines steuerbaren Ausgangstreibers. Dieser ist wiederum aus drei Stufen ausgebaut. Die ersten beiden Stufen werden wiederum parallel angesteuert und die dritte Stufe von den Ausgangssignalen der ersten beiden Stufen. Die erste Stufe enthält die komplementären Transistoren 25, 26 deren Laststrecke in Reihe geschaltet sind. Die Reihenschaltung ist zum einen mit der Anschlußklemme, an der die Betriebsspannung $V_{DD}$ anliegt verbunden. Der andere Anschluß der Reihenschaltung führt nun zu einem Anschluß 12. Ebenso ist die zweite Stufe auf den komplementären Transistoren 27 und 28 aufgebaut, deren Laststrecke ebenfalls in Reihe geschaltet sind. Die Reihenschaltung ist zum einen mit dem Anschluß 14 verbunden und zum anderen mit dem Bezugspotentialanschluß an dem die Spannung $V_{SS}$ anliegt. Die dritte Stufe bestehend aus den Transistoren 21 und 22 ist wie in FIG 3 mit den beiden ersten Stufen verschaltet.

In Abhängigkeit von dem benötigten Betriebsverhalten des Bausteins wird nun an der Anschlußklemme 12 eine Spannung mit dem Wert: $V_{SS} + U_{TN} < U_{12} < V_{DD}$ angelegt. $U_{TN}$ ist hier die Einsatzspannung eines n-Kanal Transistors. Eine höhere Spannung kann wie oben beschrieben bei veränderter Betriebsspannung, Betriebstemperatur bzw. technologiebedingten Umständen angelegt werden. In Analogie dazu wird an der Anschlußklemme 14 in Abhängigkeit von dem benötigten Betriebsverhalten der integrierten Schaltung eine Spannung mit dem Wert: $V_{DD} - U_{TP} > U_{14} > V_{SS}$ angelegt. $U_{TP}$ ist hier die Einsatzspannung eines p-Kanal Transistors. Die Spannungen $U_{12}$ und $U_{14}$ an den Anschlüssen 12 und 14 können wie oben beschrieben direkt aus dem Steuersignal am Anschluß 10 abgeleitet werden. Die Ausgangsspannung der ersten beiden Stufen kann auf diese Weise durch die jeweils an den Klemmen 12, 14 anliegende Spannung begrenzt werden. Diese Begrenzung wirkt also ebenfalls strombegrenzend für die Ausgangstransistoren 21 und 22.

Die erfindungsgemäße Anordnung eignet sich für alle integrierten Schaltungen in MOS-Technik insbesondere für Mikroprozessoren.

**Patentansprüche**

1. Anordnung zur Optimierung des Betriebsverhaltens von MOS-Treiberstufen in taktgesteuerten digitalen Schaltungen,
   **dadurch gekennzeichnet,** daß Mittel (3) vorgesehen sind, denen ein Betriebstakt und ein Referenztakt zugeführt werden und die das Verhältnis aus der tatsächlichen Betriebsfrequenz und der Referenzfrequenz bilden und daraus ein Signal erzeugen, mit dem die Schaltzeiten der MOS-Treiberstufen gesteuert werden.

**2.** Anordnung nach Anspruch 1,
**dadurch gekennzeichnet,** daß

- weitere Mittel (8) vorgesehen sind, die das Verhältnis aus den gesteuerten und ungesteuerten Schaltzeiten einer steuerbaren und einer nicht steuerbaren MOS-Treiberstufe bilden und daraus ein weiteres Signal erzeugen,
- ein Komparator (9) vorgesehen ist, dem das Signal und das weitere Signal zugeführt werden und der ein Steuersignal erzeugt, welches der steuerbaren MOS-Treiberstufe so lange zugeführt wird, bis die beiden Verhältnisse gleich sind.

**3.** Anordnung nach einem der Ansprüche 1 oder 2,
**dadurch gekennzeichnet,** daß ein Referenzoszillator (2) vorgesehen ist, dessen Ausgangssignal die Referenzfrequenz hat.

**4.** Anordnung nach einem der Ansprüche 1 bis 3,
**gekennzeichnet durch** Treiberstufen mit den Merkmalen:
die Laststrecken jeweils eines Steuertransistors (17; 18) sind in Reihe zu den Laststrecken einer komplementär aufgebauten Treiberstufe (15, 16; 19, 20) geschaltet und dem Steuereingang des Steuertransistors (17; 18) wird das Steuersignal zugeführt.

**5.** Anordnung nach einem der Ansprüche 1 bis 3,
**gekennzeichnet durch,** die Treiberstufen bei denen der Reihenschaltung der Laststrecken der Transistoren (15, 16; 29, 20) der komplementär aufgebauten Treiberstufe anstelle eines Bezugspotentials ($V_{SS}$; $V_{DD}$) das Steuersignal zugeführt wird.

## FIG 1

```
┌─────────┐      ┌─────────┐
│    1    │      │    2    │
└────┬────┘      └────┬────┘
     │                │
     └────┐    ┌──────┘
          ▼    ▼
      ┌─────────┐           ┌─────────┐
      │    3    │───────────│   11    │───○
      └─────────┘           └─────────┘   10
```

## FIG 2

```
    ┌─────────┐    ┌─────────┐
┌──▶│    4    │───▶│    5    │──┐
│   └─────────┘    └─────────┘  │
│                               │    ┌─────────┐
│                               ├───▶│    8    │──┐
│   ┌─────────┐    ┌─────────┐  │    └─────────┘  │
│   │    6    │───▶│    7    │──┘                 │
│   └─────────┘    └─────────┘                    │
│                                                 │
│   ┌─────────┐    ┌─────────┐                    │
│   │    1    │    │    2    │                     │
│   └────┬────┘    └────┬────┘                     │
│        │              │                          │
│        └───┐    ┌─────┘                          │
│            ▼    ▼                                │
│        ┌─────────┐                               │
│        │    3    │──────────┐                    │
│        └─────────┘          │   ┌─────────┐      │
│                             └───│    9    │──────┘
│                                 └────┬────┘
│                                      │
└──────────────────────────────────────●
                                        ○  10
```

FIG 3

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | US-A-3 996 481 (CHU ET AL)<br>* Spalte 6, Zeile 53 - Spalte 7, Zeile 32; Abbildungen 10,11 * | 1,3 | H03K19/003<br>H03K17/14<br>H03K3/01 |
| Y | | 4,5 | |
| Y | EP-A-0 251 910 (FUJITSU LIMITED)<br>* Spalte 4, Zeile 10 - Spalte 5, Zeile 37 *<br>* Spalte 7, Zeile 49 - Spalte 8, Zeile 19; Abbildungen 2,5 * | 4,5 | |
| A | US-A-4 972 101 (PARTOVI)<br>* Spalte 2, Zeile 25 - Spalte 5, Zeile 50; Abbildungen 1,2 * | 1-5 | |
| A | US-A-4 975 598 (BORKAR)<br>* Spalte 4, Zeile 61 - Spalte 9, Zeile 2; Abbildungen 2-8 * | 1-5 | |
| A | EP-A-0 357 532 (IBM) | 1 | |
| A | US-A-4 641 048 (POLLOCK) | 1 | **RECHERCHIERTE SACHGEBIETE (Int. Cl.5 )**<br><br>H03K |

Der vorliegende Recherchenbericht wurde für alle Patentansprüche erstellt

| Recherchenort | Abschlußdatum der Recherche | Prüfer |
|---|---|---|
| DEN HAAG | 17 DEZEMBER 1991 | FEUER F.S. |